(19)

**Europäisches Patentamt**
**European Patent Office**
**Office européen des brevets**

(11) **EP 3 330 729 B1**

(12) **EUROPEAN PATENT SPECIFICATION**

(45) Date of publication and mention
of the grant of the patent:
**28.06.2023 Bulletin 2023/26**

(21) Application number: **16201736.2**

(22) Date of filing: **01.12.2016**

(51) International Patent Classification (IPC):
**G01R 33/465** [(2006.01)]   **G01R 33/56** [(2006.01)]
**G01N 24/08** [(2006.01)]

(52) Cooperative Patent Classification (CPC):
**G01R 33/465; G01N 24/08; G01R 33/5601;**
**G01R 33/5605**

(54) **NMR METHOD FOR QUANTITATIVELY DETERMINING AN ANALYTE IN A LIQUID SAMPLE USING A HYPERPOLARIZED GAS**

NMR-VERFAHREN FÜR DEN QUANTITATIVEN NACHWEIS EINES ANALYTEN IN EINER FLÜSSIGPROBE UNTER VERWENDUNG EINES HYPERPOLARISIERTEN GASES

PROCÉDÉ PAR RMN D'IDENTIFICATION D'UN ANALYTE DANS UN ÉCHANTILLON DE FLUIDE UTILISANT UN GAS HYPERPOLARISÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**06.06.2018 Bulletin 2018/23**

(73) Proprietor: **Bundesrepublik Deutschland, vetreten durch das Bundesministerium für Wirtschaft und Technologie, dieses vertreten durch den 38116 Braunschweig (DE)**

(72) Inventors:
• **Mitschang, Lorenz**
  **10119 Berlin (DE)**
• **Kilian, Wolfgang**
  **12355 Berlin (DE)**
• **Korchak, Sergey**
  **10587 Berlin (DE)**

(74) Representative: **Bittner, Thomas L. et al Boehmert & Boehmert Anwaltspartnerschaft mbB Pettenkoferstrasse 22 80336 München (DE)**

(56) References cited:
• **MARTIN KUNTH ET AL: "Identification, classification, and signal amplification capabilities of high-turnover gas binding hosts in ultra-sensitive NMR", CHEMICAL SCIENCE, vol. 6, no. 11, 6 July 2015 (2015-07-06), pages 6069-6075, XP055371705, United Kingdom ISSN: 2041-6520, DOI: 10.1039/C5SC01400J**
• **ZAISS M ET AL: "Analytical solution for the depolarization of hyperpolarized nuclei by chemical exchange saturation transfer between free and encapsulated xenon (HyperCEST)", JOURNAL OF CHEMICAL PHYSICS, AMERICAN INSTITUTE OF PHYSICS, US, vol. 136, no. 14, 14 April 2012 (2012-04-14), pages 144106-1, XP009194353, ISSN: 0021-9606, DOI: 10.1063/1.3701178**
• **M. KUNTH ET AL: "Quantitative chemical exchange saturation transfer with hyperpolarized nuclei (qHyper-CEST): Sensing xenon-host exchange dynamics and binding affinities by NMR", JOURNAL OF CHEMICAL PHYSICS, vol. 141, no. 19, 21 November 2014 (2014-11-21), page 194202, XP055372198, US ISSN: 0021-9606, DOI: 10.1063/1.4901429**
• **YANFEI WANG ET AL: "An Expanded Palette of Xenon-129 NMR Biosensors", ACCOUNTS OF CHEMICAL RESEARCH., vol. 49, no. 10, 19 September 2016 (2016-09-19), pages 2179-2187, XP055371283, US ISSN: 0001-4842, DOI: 10.1021/acs.accounts.6b00309**

**(Cont. next page)**

- TYLER MELDRUM ET AL: "Band-selective chemical exchange saturation transfer imaging with hyperpolarized xenon-based molecular sensors", JOURNAL OF MAGNETIC RESONANCE, vol. 213, no. 1, 13 July 2011 (2011-07-13) , pages 14-21, XP028331581, ISSN: 1090-7807, DOI: 10.1016/J.JMR.2011.06.027 [retrieved on 2011-07-13]
- TODD K. STEVENS ET AL: "HyperCEST detection of a 129 Xe-based contrast agent composed of cryptophane-A molecular cages on a bacteriophage scaffold", MAGNETIC RESONANCE IN MEDICINE., vol. 69, no. 5, 12 May 2013 (2013-05-12), pages 1245-1252, XP055322762, US ISSN: 0740-3194, DOI: 10.1002/mrm.24371
- LEIF SCHRÖDER: "Xenon for NMR biosensing - Inert but alert", PHYSICA MEDICA, vol. 29, no. 1, 26 November 2011 (2011-11-26), pages 3-16, XP055371291, IT ISSN: 1120-1797, DOI: 10.1016/j.ejmp.2011.11.001
- YUBIN BAI ET AL: "Bacterial spore detection and analysis using hyperpolarized 129Xe chemical exchange saturation transfer (Hyper-CEST) NMR", CHEMICAL SCIENCE, vol. 5, no. 8, 22 May 2014 (2014-05-22), pages 3197-3203, XP055371274, United Kingdom ISSN: 2041-6520, DOI: 10.1039/c4sc01190b
- KORCHAK SERGEY ET AL: "Design and comparison of exchange spectroscopy approaches to cryptophane-xenon host-guest kinetics", JOURNAL OF MAGNETIC RESONANCE, ACADEMIC PRESS, ORLANDO, FL, US, vol. 265, 12 February 2016 (2016-02-12), pages 139-145, XP029486241, ISSN: 1090-7807, DOI: 10.1016/J.JMR.2016.02.005
- YUBIN BAI ET AL: "Utilizing a Water-Soluble Cryptophane with Fast Xenon Exchange Rates for Picomolar Sensitivity NMR Measurements", ANALYTICAL CHEMISTRY, vol. 84, no. 22, 29 October 2012 (2012-10-29), pages 9935-9941, XP055371055, US ISSN: 0003-2700, DOI: 10.1021/ac302347y
- BARTIK K ET AL: "XE AND H NMR STUDY OF THE REVERSIBLE TRAPPING OF XENON BY CRYPTOPHANE-A IN ORGANIC SOLUTION", JOURNAL OF THE AMERICAN CHEMICAL SOCIETY, THE SOCIETY, vol. 120, no. 4, 1 January 1998 (1998-01-01), pages 784-791, XP002905737, ISSN: 0002-7863, DOI: 10.1021/JA972377J
- SCHR\DER L ET AL: "Molecular imaging using a targeted magnetic resonance hyperpolarized biosensor", SCIENCE, AMERICAN ASSOCIATION FOR THE ADVANCEMENT OF SCIENCE, vol. 314, 20 October 2006 (2006-10-20), pages 446-449, XP002476683, ISSN: 0036-8075, DOI: 10.1126/SCIENCE.1131847
- SERGEY KORCHAK ET AL: "Degeneracy in cryptophane-xenon complex formation in aqueous solution", CHEMICAL COMMUNICATIONS - CHEMCOM., vol. 51, no. 9, 17 December 2014 (2014-12-17), pages 1721-1724, XP055371043, ISSN: 1359-7345, DOI: 10.1039/C4CC08601E

**Description**

The present disclosure refers to a method for quantitatively determining an analyte in a liquid sample.

Background

Nuclear magnetic resonance (NMR) is a versatile spectroscopy and imaging approach to obtain structural and functional information at the molecular and systemic levels. While usually a high concentration of the molecules of interest is required, recent progress is based on novel techniques using polarization enhancement of the nuclear spin for the detection of rare species or events. Of particular interest is the spin-1/2 isotope $^{129}$Xe. Prior to their application as a NMR probe, the spins can be brought up by collisions in the gas phase with laser-polarized alkali metals to a polarization five orders of magnitude higher than in the usually used thermal equilibrium in a strong magnetic field (see Walker et al., Rev Mod Phys 69, 629-642 (1997)). Such hyperpolarized $^{129}$Xe (hpXe) retains the excellent sensibility of the xenon chemical shift (signal position) to its local environment. Taking the good biocompatibility of the noble gas into account, hpXe is predestined for NMR applications in biomedicine. While its usage in the medical imaging of lungs is developed to a level suitable for the clinics, possible applications in biomarker targeting and visualization by molecular imaging are presently explored.

An achievement towards this goal is the availability of host structures where hpXe can bind to reversibly. By their functionalization specific targets with whom otherwise bare xenon would only interact nonspecifically are selected. Within the variety of suitable xenon hosts identified so far, ranging from molecular moieties with single or multiple xenon binding sites to genetically encoded bacteria, the molecule cryptophane-A (CrA) has emerged to be of particular relevance. The container-shaped molecule can enclose and bind non-covalently a single xenon atom. The tight fit causes xenon to remain bound for some milliseconds and to adopt a very different chemical shift than in the surrounding solution (see Bartik et al., J Am Chem Soc 120, 784-791 (1998)). Xenon is thus in slow exchange on the NMR timescale when changing its binding status with respect to, possibly target-bound, CrA, and these states can be clearly distinguished by well separated signals. Further on, the reversibility of complex formation with CrA allows a multitude of hpXe to be associated - albeit for a limited period - with the target, a property that can be explored for a further enhancement of detection sensitivity as is required for the ultimate sensing of biomarkers at native concentration levels. This is facilitated by the chemical exchange saturation transfer method, termed Hyper-CEST when referring to hpXe (see Schröder et al., Science 314, 446-449 (2006)).

In Hyper-CEST magnetization of CrA-bound hpXe is continuously deleted, e.g. saturated by radiofrequency (rf) irradiation. Because of the reversible and thus continuously renewed complex formation with CrA of otherwise free xenon, the magnetization of unbound hpXe is also continuously diminished. The CrA-bound xenon can be monitored indirectly with largely amplified sensitivity by the reduction in signal intensity of unbound hpXe, rather than being directly observed. A comparison of signal intensities with and without saturation transfer clearly indicates the presence of the host structure. A number of recent in-vitro studies have proven the high potential of the CrA-hpXe host-guest system in conjunction with the Hyper-CEST method to report on the presence and activity of biomarkers, including enzymes, molecular transporters, and immunologically relevant proteins, and, further on, recognition and imaging of cell types has been established in a phantom setup.

The results obtained so far are of a qualitative nature, demonstrating the approach's basic applicability and adequacy in terms of biocompatibility, specificity and sensitivity. Recently, Hyper-CEST was applied to CrA for an estimation of parameters intrinsic to the method by a variation of the saturation power and multivariate, nonlinear data fitting (see Kunth et al., Chem Sci 6, 6069-6075 (2015) and Journal of Chemical Physics, vol. 141, no. 19, 21, Nov. 2014, article 194202), and limits of detection were empirically probed (see Bai et al., Anal Chem 84(22), 9935-9941 (2012)). However, a more detailed understanding is necessary to fully harvest the potential of the approach for sensing and imaging.

Summary

It is an object of the present disclosure to provide a method for quantitatively determining an analyte in a liquid sample.

A method for quantitatively determining an analyte in a liquid sample according to the independent claim is provided. Alternative embodiments are disclosed in dependent claims.

According to an aspect, a method for quantitatively determining an analyte in a liquid sample is provided. The method comprises providing a liquid sample comprising an analyte of interest and a marker substance bound to the analyte. A mixed liquid sample is prepared by mixing the liquid sample with a hyperpolarized gas, the marker substance and the hyperpolarized gas providing a host-guest system in the mixed sample, wherein the hyperpolarized gas is having a shift of nuclear magnetic resonance frequencies in case of a transition from a freely dissolved state to a host-bound state in which the hyperpolarized gas is bound to the marker substance in the mixed sample. The mixed sample is experimentally determined by nuclear magnetic resonance (NMR) spectroscopy. From results of the NMR spectroscopy a concentration of the hyperpolarized gas in the mixed liquid sample is determined for at least one of the freely dissolved state and the host-bound state of the hyperpolarized gas. Following, the analyte in the liquid sample is quantitatively determined.

In the host-bound state the hyperpolarized gas may be provided in an encapsulated-bound state. The hyperpolarized gas may be encapsulated in a molecular cage provided by the marker substance bound to the analyte in the mixed sample.

The freely dissolved state of the hyperpolarized gas may also be referred to as unbound state.

The method may further comprise: the experimentally determining of the mixed sample comprises experimentally determining a ratio of NMR signal intensities for the freely dissolved state and the host-bound state of the hyperpolarized gas; and the determining of the concentration of the hyperpolarized gas comprises determining the concentration of the hyperpolarized gas in the host-bound state in the mixed liquid sample from the ratio of NMR signal intensities for the freely dissolved state and the host-bound state of the hyperpolarized gas.

The experimentally determining comprises applying a Hyper-CEST method.

The applying comprises establishing, in a first measurement, a saturation transfer for the hyperpolarized gas in the freely dissolved state and the host-bound state.

The applying comprises establishing, in a second measurement, a non-saturation transfer for the hyperpolarized gas in the freely dissolved state and the host-bound state.

The experimentally determining comprises depolarizing the hyperpolarized gas in the host-bound state, and detecting NMR signals for the hyperpolarized gas in the freely dissolved state. The depolarizing may comprise complete deletion of the magnetization of the host-bound hyperpolarized gas.

The depolarizing comprises depolarizing the hyperpolarized gas in the host-bound state by applying radio frequency (rf) irradiation. With regard to frequency, the rf irradiation is in resonance with the hyperpolarized gas in the host-bound state. The rf irradiation pulses are provided with a time length $\tau$ (pulse length) and amplitude w enabling full or partial saturation.

The quantitatively determining comprises applying, in a signal analysis, a model function for the NMR signal $S$

$$S(\rho, \tau) = A(\rho)e^{-R'(\rho)\tau} - A(\rho)e^{-(R+k_{on}(\rho))\tau}$$

wherein $\rho$ - concentration of the hyperpolarized gas in the freely dissolved state, $\tau$ - time length of a depolarization (rf irradiation) period, $k_{on}$ - association rate for binding of the hyperpolarized gas to the marker substance, $R$ - relaxation and direct saturation rate in case of rf irradiation resonant with the host-bound hyperpolarized gas, and $R'$ - relaxation and direct saturation rate in case of rf irradiation off-resonant with the host-bound hyperpolarized gas. The parameters may be determined from fitting the experimental NMR signals based on the model function or may be known a priori. $R'$ and $R+k_{on}$ characterize the decay of the NMR signals.

The model function may be applied for $R \cong R'$. The relaxation rates are essentially equal at the low concentration levels considered here.

The model function may comprise a factor $w^2/(w^2+k_{off}^2)$, wherein $w$ is a saturation rf-irradiation power expressed in units of the precession frequency of the hyperpolarized gas, and $k_{off}$ is a dissociation rate of a marker substance - hyperpolarized gas complex.

The providing may comprise providing a liquid sample with the marker substance selected from the following group: xenon binding substance, cryptophane, and cucurbituril.

In an alternative method, an explicit resolution of the model function for determining the analyte concentration (concentration of the marker substance) may be conducted. The analyte concentration is determined from the Hyper-CEST effect using prior knowledge about the parameters describing properties of the hyperpolarized gas, e.g. xenon, its spin and the exchange dynamics with the host. In an alternative embodiment, the method may apply an explicit resolution of the part of the model function describing only the association rate ($k_{on}$) with determination of the analyte concentration (concentration of the marker substance) from measurements of the depletion rates ($R'$, $R+k_{on}$) by repetitions of the Hyper-CEST experiment and using prior knowledge about parameters, such as spin and exchange parameters. In still another alternative method, a comparison of the depletion rate for an unknown analyte concentration with the rate for a known analyte concentration (reference) may be applied.

The preparing may comprise mixing the liquid sample with hyperpolarized Xe (hpXe).

In an alternative method for quantitatively determining an analyte in a liquid sample NMR signals (nuclear magnetic resonance (NMR) spectroscopy) are detected for a hyperpolarized gas which is present in the liquid sample. Further, the liquid sample is containing a marker substance bound to the analyte. The liquid sample comprises a mixture of the analyte, the marker substance bound to the analyte, and the hyperpolarized gas. The hyperpolarized gas is in a freely dissolved state and a bound state, respectively. The hyperpolarized gas together with the complex containing the analyte and the marker substance bound to the analyte provides for a host-guest system. The hyperpolarized gas is in the bound state if it is bound to the marker substance in the complex of analyte and marker substance. In the method, NMR signals are detected for both the hyperpolarized gas in the bound state and the hyperpolarized gas in the freely dissolved (unbound) state. The NMR signals assigned to the hyperpolarized gas in the freely dissolved state and the bound state, respectively, may have different chemical shift, the chemical shift being the resonance frequency of a nucleus relative to a standard in a magnetic field. Chemical shift $\delta$ may be expressed in parts per million (ppm) by frequency.

If, for the liquid sample, the concentration of the hyperpolarized gas in the freely dissolved state is known, the NMR signals detected for the hyperpolarized gas in the freely dissolved state and the hyperpolarized gas in the bound state, respectively, may be compared for determining the concentration of the hyperpolarized gas in the bound state in the liquid sample. For example, parameters such as signal level, signal intensity and / or the integral of the NMR signals may be analyzed for comparing the NMR signals. Further, from the result of such analysis a concentration of the analyte of interest in the liquid sample can be determined. In conclusion, the concentration of the analyte in the liquid sample is determined indirectly by comparing the NMR measurement results (NMR signals) for both the hyperpolarized gas in the freely dissolved state and the hyperpolarized gas in the bound state.

The hyperpolarized gas may be xenon, for example hyperpolarized Xe (hpXe). The host-guest system may comprise cryptophane-A (CrA) and hyperpolarized Xe.

With regard to the analyte binding to the hyperpolarized gas, saturation may be provided in the liquid sample. In this case there would be no analyte without marker bound to it. In an alternative method, a relative amount of the analyte in a liquid sample may bind a hyperpolarized gas, wherein such relative amount is known. The concentration of the hyperpolarized gas in the liquid sample may be determined in dependence on the solubility of the hyperpolarized gas in the liquid sample for given conditions, specifically conditions regarding pressure and temperature. For example, information on the solubility of a hyperpolarized gas in different solvents is available from the literature. In addition or as an alternative, solubility of the hyperpolarized gas in a solvent may be determined by experimental methods known as such. Such concentration can be assigned to the NMR signal detected for the freely dissolved hyperpolarized gas (unbound hyperpolarized gas). Comparing such NMR signal to the signal detected for the hyperpolarized gas bound to the analyte will allow for determination of the concentration of the hyperpolarized gas bound. From the concentration of the hyperpolarized gas bound to the analyte in the liquid sample the concentration of the analyte in the liquid sample can be determined.

Quantitatively determining may comprise applying a Hyper-CEST technology.

In the embodiments of the method described here, the marker may be a biosensor in the liquid sample. In the different embodiments the method may be applied for determining a biological liquid sample comprising a biomolecule, for example peptide, protein, DNA, and / or RNA. The biomolecule may be part of a complex comprising other molecules or a cell.

The NMR measurement may comprise accumulative detection of the NMR signals. A plurality of NMR spectra may be detected. Following, the NMR spectra may be added.

According to a further aspect an assay may be provided which is configured for quantitative determination of an analyte in a liquid sample by means of NMR measurements, wherein a hyperpolarized gas detectable by NMR measurement is provided in a freely dissolved state and a bound state.

According to another aspect the quantitation may be applied in a multiplexing mode by in parallel targeting various analytes by different marker substances in the same sample or solution. In an alternative embodiment, the method for quantitatively determining one or more analytes may be used in or with an assay.

The methods may be used for quantitatively determining an analyte in a liquid *ex-vivo* biological sample, specifically for quantitatively determining an analyte in a liquid *ex-vivo* sample of a bodily fluid. Alternatively, the methods may be applied for an *in-vivo* application, which however is not part of the present invention.

A bodily fluid as a sample with the context of the present disclosure may be selected from the group comprising blood, serum, plasma, urine, cerebro spinal liquid (csf), and saliva. With the context of the instant invention said bodily fluid is an ex vivo sample. In an alternative embodiment the sample may be selected from the group comprising a blood sample, a serum sample, a plasma sample, a cerebrospinal fluid (csf) sample, a saliva sample and a urine sample or an extract of any of the aforementioned samples. With the context of the present disclosure said sample of a bodily fluid is an *ex-vivo* sample.

The term "sample" as used herein may refer to an *ex-vivo* sample of bodily fluid obtained for the purpose of diagnosis, prognosis, or evaluation of a subject of interest, such as a patient. Preferred test samples include blood, serum, plasma, cerebrospinal fluid, urine, saliva, sputum, and pleural effusions. In addition, one of skill in the art would realize that some test samples would be more readily analyzed following a fractionation or purification procedure, for example, separation of whole blood into serum or plasma components. Thus, in an embodiment of the method said sample is selected from the group comprising a blood sample, a serum sample, a plasma sample, and a urine sample or an extract of any of the aforementioned samples.

The methods may be applied to determining liquid samples having a sub-micomolar ($\mu$M) analyte concentration. A nanomolar (nM) or a sub-nanomolar analyte concentration may be provided in the liquid sample.

Description of embodiments

Following, further aspects are disclosed by referring to Figures. The figures show:

Fig. 1a     a schematic representation of components of a host-guest system comprising crypto-phane-A (CrA) and hyperpolarized Xe;

Fig. 1b     a schematic representation of NMR signals from the host-guest system for resonant and off-resonant rf irradiation with respect to host-bound xenon;

Fig. 1c     a graphical representation of calculation with regard to a model function together with experimental data;

Fig. 2a     dilution series in the host concentration for determination of maximum Hyper-CEST effect at 298 K and 310 K at the respective optimal xenon partial pressure and saturation (rf irradiation) period;

Fig. 2b     for the host-guest system, a graphical representation of depletion curves for resonant irradiation and off-resonant irradiation at various host concentration and at 298 K obtained by exponential fitting;

Fig. 2c     a diagram and data equivalent to Fig. 2b for 310 K;

Fig. 3     a graphical representation of a polarization of hpXe in dependence on xenon partial pressure; and

Fig. 4     a graphical representation of an evaluation of the model function for the Hyper-CEST effect at temperature 298 K for an aqueous solution of CrA of (a) 0.9 nM, (b) 9 nM, (c) 90 nM, and (d) 900 nM, and at 310K for CrA concentrations of (e) 0.9 nM, (f) 9 nM, (g) 90 nM, and (h) 900 nM.

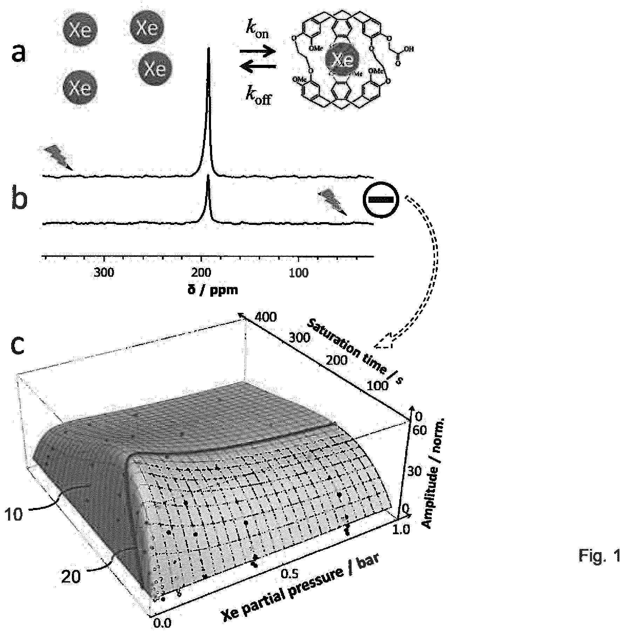

The experiment situation explored for analyte quantitation is displayed in Fig. 1a to 1c.

The host CrA and the guest hpXe (hyperpolarized Xe) combine and dissociate rapidly in solution (see Fig. 1a). Upon selective, resonant rf irradiation (rf - radio frequency) of CrA-bound xenon, the free xenon spins get depolarized because of saturation transfer by chemical exchange. In solution hpXe binds reversibly to the host (CrA) with association and dissociation rates $k_{on}$ and $k_{off}$, respectively.

Referring to Fig. 1b, the saturation of the magnetization of host-bound hpXe by resonant rf irradiation leads to a diminished free hpXe signal which is easily detected as a strong NMR signal. The signal vanishes at characteristic rate $k_{on}$ in comparison to the case for mirror-symmetrical off-resonant irradiation. The acquired and processed free xenon signal shows up at 196 ppm in the spectra (Fig. 1b) while the signal of CrA-bound hpXe at 65 ppm is not visible at this concentration level.

To reference the decay due solely to saturation transfer, a second experiment is conducted in an identical manner but with the rf irradiation applied off-resonantly at a position mirror-symmetrically with respect to the free xenon signal. In this case, saturation transfer cannot occur but any effect of direct saturation possibly due to the resonant irradiation of CrA-bound spins is identically included. The difference in the intensity of the free xenon signal without or with saturation transfer, termed Hyper-CEST effect, is indicative of the xenon host and generates a contrast for MRI (see Schröder et al., Science 314, 446-449 (2006)).

Referring to Fig. 1c, the Hyper-CEST effect is the difference in signal intensities for off-resonant and resonant irradiation and can be mapped in dependence of the saturation transfer (rf irradiation) period and the free xenon concentration (or free xenon partial pressure). Experimental data (dots 10) are superimposed on the model function $S(\rho, \tau)$ (see below) evaluated for the parameter settings presented in Table 1 (see below) and a host concentration of 90 nM. The crest line 20 indicates maximum Hyper-CEST effect for each choice of xenon partial pressure. Experiments were performed on a sample of 90 nM CrA in aqueous solution at 298 K.

The method is outlined in following. A model function is proposed as follows:

$$S(\rho, \tau) = A(\rho) e^{-R'(\rho)\tau} - A(\rho) e^{-(R + k_{on}(\rho))\tau}$$

for describing this type of experiment. The variables are the concentration of freely dissolved xenon $\rho$ and the length of the saturation transfer (rf irradiation) period $\tau$.

In the model function, the second term refers to the NMR signal in case of the resonant irradiation (saturation transfer), while the first term indicates the NMR signal for off-resonant irradiation (no saturation transfer).

The model function provided above may be applied for fitting curves of NMR signals detected for the host-guest system for quantitatively determining the analyte in the liquid sample, specifically the analyte concentration.

It is important to note that both variables, $\rho$ and $\tau$, can be set quite freely. Nowadays NMR equipment allows rf irradiation at low power for periods in the range of microseconds to minutes, while the free xenon concentration within a sample subjected to a xenon atmosphere can be controlled via the xenon partial pressure. Practically, the solution is saturated with hpXe by bubbling of the gas for some seconds through the sample.

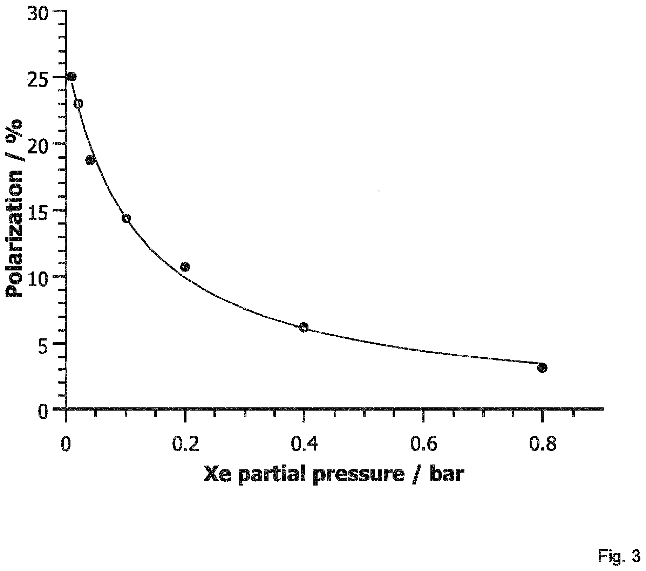

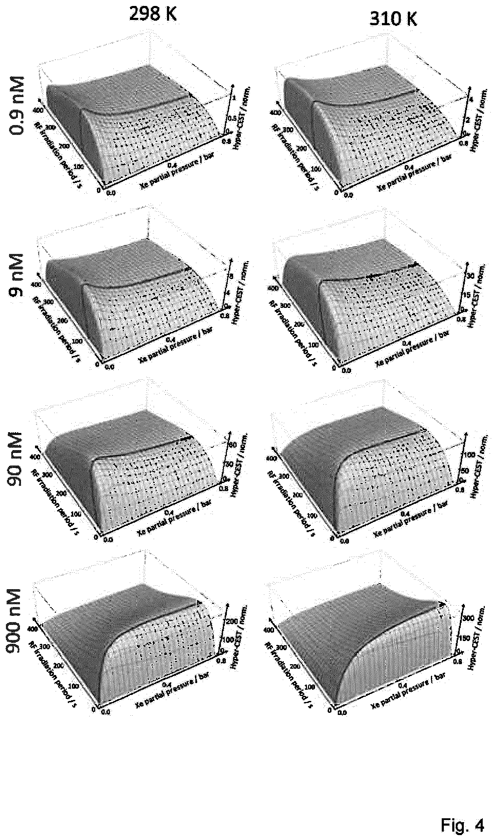

In the model function, the leading amplitude factor is the initial ($\tau = 0$) free hpXe magnetization, $A(p) = rP\rho$ with P for the spin polarization and r for the fraction of $^{129}$Xe in the xenon atmosphere. The data discussed here refer to non-enriched xenon gas with a natural abundance of $^{129}$Xe of $r$=0.26. The spin polarization $P$ is dependent again on the xenon concentration, this time of the xenon gas in the optical pumping cell for the generation of hpXe prior to delivery to the sample, $P = P_0(1 + \alpha p)^{-1}$. The xenon gas partial pressure $p$ is related to the hpXe concentration in the sample by Henry's law, $\rho = sp$, where s denotes the xenon solubility of the solution. The constant $P_0$ represents the maximum polarization which is obtained at vanishing xenon density, it is e.g. $P_0 \approx 0.25$ for the polarizer used for the experiments in Fig. 1 (see Korchak SE, Kilian W, Mitschang L, Appl Magn Reson 44, 65-80 (2013)). The coefficient $\alpha$ can be determined empirically (see also discussion regarding Fig. 3 and 4 below with a derivation of the functional form for $P$ provided below).

The first term in the model function represents the signal intensity for off-resonant irradiation of length $\tau$. The rate $R'(\rho)$ comprises two contributions, one due to longitudinal relaxation and one due to possible direct rf saturation effects from the irradiation (see Zaiss et al., J Chem Phys 136(14), 144106 (2012)). The longitudinal relaxation time of hpXe is typically in the range of minutes in aqueous solution and tens of seconds when bound to CrA. Because the residence time of xenon at CrA is on the millisecond scale, $R'(\rho)$ comprises an effective relaxation rate given by the population averaged - and thus $\rho$-dependent - mean of the relaxation rates in bound and unbound states. The weights are the concentration of free xenon, $\rho$, and the concentration of xenon occupied host, $K\rho C^{tot}/(1+K\rho)$ where $C^{tot}$ denotes the total CrA concentration and $K$ the complex association constant. However, in most application, like the ones presented here, $R' \approx R$ because of the low host concentration.

The final term in the model function represents the free xenon signal intensity when the CrA-bound spins are saturated by resonant irradiation for a period $\tau$. Here, $R$ comprises an irradiation related component identical to the one discussed for $R'(p)$ and the longitudinal relaxation rate of free xenon in the solution when no host is present. It is assumed that the magnetization of hpXe after entering the host is completely destroyed by rf saturation at the time of leaving the complex. Spin relaxation then only occurs when residing in free solution.

The chemical exchange of hpXe driving the Hyper-CEST effect enters the model function via the rate $k_{on}(\rho)$ for complex formation with CrA, given by $k_{on}(\rho)=(c+k\rho)KC^{tot}/(1+K\rho)$ (see Korchak et al., J Magn Reson 265, 139-145 (2016)). The first factor $c+k\rho$ is the complex dissociation rate due to spontaneous decay and xenon release from the complex due to competitive binding partners other than xenon with rate coefficient $c$ and degenerate exchange with rate coefficient $k$, respectively (see Korchak et al., Chem Commun 51, 1721-1724 (2015)). The second factor is the ratio of the concentration of xenon occupied CrA to the concentration of free xenon.

With regard to the NMR signal, in case of resonant irradiation (saturation transfer) the signal vanishes at the characteristic rate $k_{on}$ in comparison to the case for off-resonant irradiation (no saturation transfer), as for low host concentration where the method may usually be applied to, $R' \approx R$.

The parameters entering the model function, related either to hpXe, its spin properties or the exchange kinetics, can be determined independently from the Hyper-CEST approach. The relaxation rate of hpXe, either in solution or bound to a host, as well as the kinetic rate coefficients can be readily obtained by NMR using established measurement protocols (see Korchak et al., J Magn Reson 265, 139-145 (2016)). Importantly, such measurements may be done at much higher host concentration than used in future applications while the results remain valid as long as the sample temperature and the solution conditions are kept. When the contribution from direct saturation becomes relevant, $R' \approx R$ may be simply determined as part of the Hyper-CEST experiment for off-resonant irradiation applied at various durations. The association constant for hpXe binding to CrA can be conveniently determined by fluorescence quenching as previously demonstrated (see Hill et al., J Am Chem Soc 129, 9262-9263 (2007)).

Concerning the xenon solubility in solution, the Ostwald coefficient may be found tabulated, particularly for pure organic solvents and water (see Clever HL, Solubility Data Series, ed Kertes AS. Vol. 2 (Pergamon press), 134-227 (1979)), but it is also known for physiologically relevant solutions, plasma and blood based on the early use of the radioactive xenon-133 in medicine medicine (see Kitani et al., Clin Lab Invest 29, 167-172 (1972); Yeh et al., Pharm Sci 53(7), 822-824 (1964)). In this manner the relevant parameters for the CrA-hpXe host-guest system were specified in aqueous solution at the two different temperatures 298 K and 310 K. This data are collected in Table 1.

It is not specified a priori a global amplitude factor for the model function. It is evident that, depending on the equipment configuration at hand, only a certain fraction of the originally generated polarization will survive and be available in the sample for the NMR experiment. A similar dependence on the NMR instrumentation holds for the Hyper-CEST effect in absolute terms, as it is derived from acquired spectra. It is thus required to obtain the overall amplitude of the model function by a normalization procedure with respect to the experimental data. The aforementioned parameters $r$ and $P_0$, related to the magnetization of hpXe in the sample and thus contributing also to the amplitude of the Hyper-CEST effect, can than be considered absorbed in the overall amplitude factor.

Table 1: Physical parameters for monoacidic acid CrA and hpXe in water.

| | $s$/Mbar$^{-1}$ | $\alpha$/bar$^{-1}$ | $R$/s$^{-1a}$ | $c$/s$^{-1}$ | $k$/M$^{-1}$s$^{-1}$ | $K$/M$^{-1}$ |
|---|---|---|---|---|---|---|
| 298 K | 0.00432±0.00005 | 8.36±0.76 | 0.00662±0.00012$^b$ | 20.0±0.3 | 5800±280 | 58400±6800 |
| 310K | 0.0032510.00003 | 8.36±0.76 | 0.0049410.00014 | 74.1±2.5 | 1240012600 | 28900±2200 |

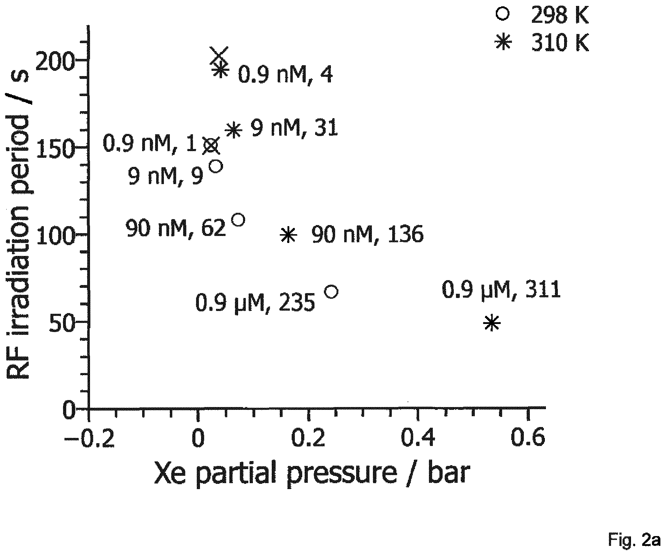

$^a$$R'\approx R$ at low host concentration.
$^b$$R=0.00594\pm0.0002$ s$^{-1}$ for the samples of the dilution series at 298 K (Fig. 2a).

The validity of the model function in describing the Hyper-CEST effect can be tested by comparison of calculations with experimental outcomes. To this end, a solution of 90 nM of the water-soluble derivative monoacetic acid cryprophane-A in pure water was saturated with hpXe gas by bubbling. Before excitation and detection of the free xenon spins, either saturation transfer was effective or not by applying resonant or off-resonant irradiation, respectively. A total number of 70 repetitions of both types of experiment were performed with 10 settings of the irradiation period in between 0 s and 350 s, and, independently, 7 settings of the xenon partial pressure in between 0.01 bar and 0.8 bar (amounting to a range of 43 $\mu$M to 3.5 mM for the free xenon concentration in the solution at a solubility of 4.32 mM bar$^{-1}$ for xenon in water at 298 K). The temperature of the sample was held constant at 298 K.

The Hyper-CEST effect was obtained as the difference of the intensity of the free xenon signal in the experiments without and with saturation transfer for a period the same length and conducted at the same xenon partial pressure.

For comparison, the model function was evaluated over a similar range for the variables $\rho$ and $\tau$ using the parameters listed in Table 1. Only the global amplitude of $S(\rho,\tau)$ was adjusted in a least-squares fit to the experimental data.

It is evident from Fig. 1c that the model reproduces the measurements quite well. A quantitative measure for the fit of the model function to the data may be seen in the root-mean-square deviation relative to the average Hyper-CEST effect (coefficient of variation) of 0.15.. However, considering only the data obtained with comparatively small $\tau$ < 25 s a large relative RMSD of more than 2 prevails while it drops to 0.08 when considering the data with settings $\tau \geq$ 25 s only. It is for the longer periods that the free xenon signal is appreciably diminished by saturation transfer from CrA-bound hpXe, to an extent surpassing the fluctuations in the measurements.

The model function and the corresponding experimental data in this example are a rather flat function in the variables $\rho$ and $\tau$, except for a smooth decline towards small $\tau$ and a steeper one towards small $\rho$. Remarkable is the single, global maximum which is located at position $p_{max}=74$ mbar and $\tau_{max}=108$ s. Such a setting of $\rho$ and $\tau$ enables, for the given experimental equipment and sample, the performance of a maximum Hyper-CEST effect in sensing and imaging applications.

In general, for a given free xenon concentration $\rho$ the Hyper-CEST effect adopts a maximum if the irradiation period is set to render the derivative of $S(\rho,\tau)$ with respect to r vanishing, i.e. at $\tau_{max}$ =(ln[$R+k_{on}(\rho)$]-ln[$R'(\rho)$])/($R-R'(\rho)+k_{on}(\rho)$). The crest line of maximum Hyper-CEST effect for any choice of $\rho$ (Fig. 1c) is now given explicitly by $S(\rho,\tau_{max}(\rho))$. Viewed as a one-dimensional function of the variable $\rho$, the position of the single maximum $\rho_{max}$ which is also the $\rho$-coordinate of the maximum of the two-dimensional function $S(\rho,\tau)$ can now be determined conveniently. Despite $S(\rho,\tau_{max}(\rho))$ being analytical, $\rho_{max}$ could only be determined numerically by nested intervals for finite host concentration. The optimal saturation period can then be obtained by evaluating the expression for $\tau_{max}$ at $\rho_{max}$.

It is clear that the details of the topology of the surface $S(\rho,\tau)$, or the performance of Hyper-CEST, depend on the physical parameters of the system under investigation (Table 1). The performance of the polarizer described by $A(p)$ in the model function is assumed to be sufficiently stable and repeatable over a period much longer than a typical Hyper-CEST experiment ($\tau_{max}$) and, thus, to possibly contribute fluctuations but not to render the overall appearance of $S(\rho,\tau)$ differently when the sample or sample conditions are changed. In typical applications of Hyper-CEST the host concentration is orders of magnitude below the free xenon concentration such that the relaxation related components of $R$ and $R'(\rho)$, and thus the rates themselves, are very comparable and simply induce a virtually identical exponential decay in the experiments. The distinguished features of Hyper-CEST therefore originate from the magnetization transfer rate $k_{on}(\rho)$. The dependence of $k_{on}(\rho)$ on the kinetic rate coefficients and the binding constant makes the Hyper-CEST effect specific to the host-guest interaction at the molecular level, rendering the method temperature dependent. A strong response in $S(\rho,\tau)$ may be also expected from changes in the total host concentration because of the proportionality to $k_{on}(\rho)$. It may thus be advantages to use the model function as a tool to predict, and possibly to optimize, applications of Hyper-CEST under different conditions of temperature or host concentration.

To this end, the system parameters governing $S(\rho,\tau)$ were determined independently of the Hyper-CEST method also for a temperature of 310 K (Table 1). The relaxation rates and kinetic coefficients adopt at 310 K different numerical values, which are of particular relevance for in-vivo applications, such that the Hyper-CEST effect changes correspondingly. The model function was finally evaluated using the parameters at 298 K or at 310 K and assuming different levels of host concentration (see Fig. 4). Evidently, the overall topology changes with a trend towards a more peaked shape for a smaller amount of host molecules in the solution and a host concentration dependent location of the maximum.

The positions in the $\rho, \tau$-plane of the model function's maximum for host concentrations of 900 nM, 90 nM, 9 nM, and 0.9 nM at 298 K and 310 K, respectively, was studied. The location of the maximum of the Hyper-CEST effect moves due to the dependence of the exchange rate $k_{on}$ on the total host concentration. However, with ever smaller host concentration the maximum location strives towards a fixed location around $\rho_{max}$=26 mbar, $\tau_{max}$=153 s for 298 K and $\rho_{max}$=40 mbar, $\tau_{max}$=200 s for 310 K, respectively. For vanishing $C^{tot}$, the decay rate $R'(\rho)$ approaches $R$ and $\tau_{max}$ becomes constant to $1/R$. In this low concentration range, also the Hyper-CEST effect is miniscule. Indeed, $S(\rho, \tau)$ vanishes allover for vanishing host concentration, rendering the Hyper-CEST effect indifferent to changes in $\rho$. By Taylor expansion of the model function in $C^{tot}$, the $\rho$-position of the maximum for vanishing host concentration can be determined as 24.4 mbar and 37.8 for 298 K and 310 K, respectively.

Hyper-CEST was performed in a dilution series in $C^{tot}$ to determine the detection limit of CrA at the maximum Hyper-CEST effect for both temperatures. At the constant settings $\rho_{max}$=26 mbar at 298 K and $\rho_{max}$=40 mbar at 310 K the period $\tau$ for off- resonant or resonant irradiation was varied from 0 s to 400 s, and the respective signal decay in dependence of $\tau$, the so-called depletion curve, monitored at the various host concentrations.

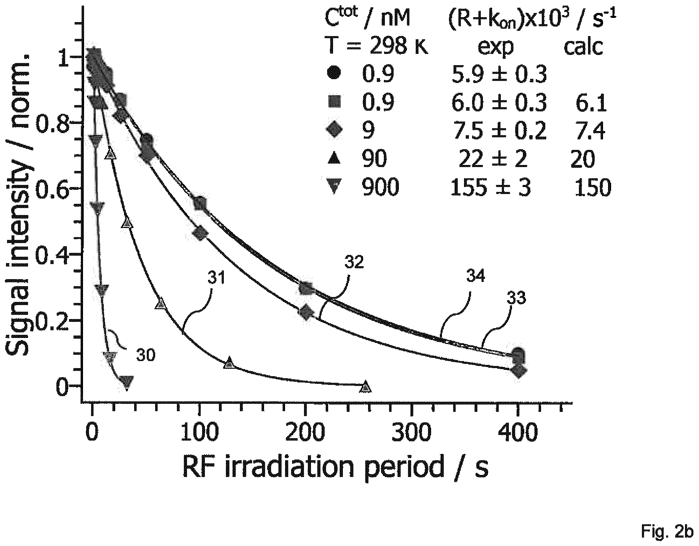

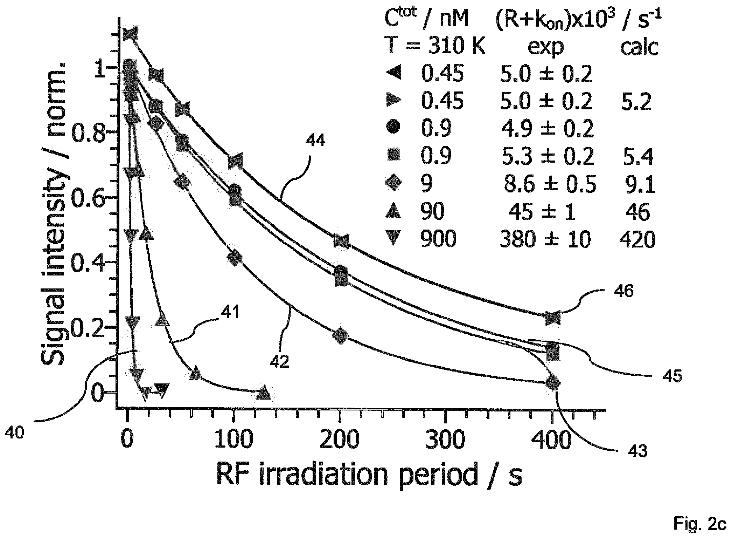

Referring to Figs. 2a to 2c, aspects of an optimization of the Hyper-CEST performance are depicted. Referring to Fig. 2a, for dilution series in the host concentration at 298 K and 310 K the location of the maximum Hyper-CEST effect in the $\rho, \tau$-plane is depicted. Experimental data for the respective detection limits are shown in Figs. 2b and 2c, together with calculated depletion rates for comparison. Fig. 2b shows depletion curves for resonant irradiation 30, ..., 33 and off-resonant irradiation 34 at the various host concentration and at 298 K obtained by exponential fitting to the marked experimental data. Fig. 2c shows a diagram and data equivalent to Fig. 2c for 310 K. The depletion curves for 0.45 nM host concentration are artificially modified by addition of a constant offset of 0.2 to improve their visibility in the chart. In Fig. 2d curves for on-resonant irradiation 40, ..., 44 and off-resonant irradiation 45, 46 are shown.

As shown in Figs. 2b and 2c, the Hyper-CEST effect for 9 nM or 0.9 nM host concentration at 298 K or 310 K, respectively, can be observed as a slight deviation of the depletion curves. While the curves coincide in the beginning and end, the maximum distance between the curves appears around $\tau_{max}$=1/R, i.e. ~150 s and ~200 s for 298 K and 310 K, respectively, as expected.

Upon further dilution to 0.9 nM and 0.45 nM for 298 K and 310 K, respectively, also the separation of the depletion curves disappears at the optimal pressure settings ($\rho_{max}$), making that host concentrations indistinguishable by the Hyper-CEST effect (see Figs. 2b, 2c). Because of the model functions peaked nature and the displacement of the maximum's position, the necessity for optimization for investigations at the limit of detection becomes obvious. For example, the polarizer can be operated down to a xenon partial pressure of $p$=5 mbar where the practically achievable polarization is at most. Naively, when working at that setting, the Hyper-CEST effect would be less than half in comparison to the optimal setting.

The model function is used for quantification of parameters. The amount of host molecules present in the solution was determined which is the quantity of interest for many targeting applications. A first attempt is to resolve the model function for $C^{tot}$. This approach, however, is only feasible at low host concentration, when $R'(\rho) \approx R$ as then $C^{tot}$ can be explicitly expressed in terms of the NMR parameters and the measured Hyper-CEST effect. In the case of 90 n.M host concentration at 298 K, a difference of less than 1% in the rates $R'(\rho)$ and $R$ over the range of xenon partial pressures used in the experiments is marginal in this respect. From the 70 experimental intensity differences of this dataset (Fig. 1c), a subset of 55 was selected by the exclusion of the cases where the resolved formula is mathematically not applicable (negative argument of Logarithm, or result of a negative host concentration) and of the cases for zero rf-irradiation period, where only fluctionations (noise) are detected. The mean concentration with standard deviation (SD) $89.8 \pm 4.3$ nM is obtained in this manner. This excellent result can be attributed to the large number of samples contributing to the average. The aforementioned coefficient of variation in the dataset indicates much less accurate results when applied to a single Hyper-CEST effect.

An alternative embodiment is to use the saturation driven depletion rate $R + k_{on}(\rho)$ instead of the Hyper-CEST effect itself for quantification. This rate is simply linearly dependent on the host concentration and may be easily determined from a fit to the experimentally determined NMR signal depletion curve (curve fitting). An advantage of this approach comes thus with the inherent statistical averaging due to the determination of the depletion rate by fitting to a number of experimental data points. For the seven depletion curves at 90 nM host concentration and 298 K, each conducted at a fixed xenon partial pressure and at 10 different settings of the irradiation period, the mean with SD $92.2 \pm 5.0$ nM is obtained. This approach it is directly applicable to the individual depletion curves of the dilution series in the host concentration (data in Figs. 2b and 2c). For 298 K, the nominal concentrations of 900 nM, 90 nM, 9 nM, and 0.9 nM were matched by the determinations $930 \pm 56$ nM, $98 \pm 12$ nM, $9.7 \pm 1.8$ nM, and $0.50 \pm 2.1$ nM, respectively. Interestingly, the correct order of magnitude at the low concentration of nominal 0.9 nM could be probed in this manner despite not affecting a sufficiently strong Hyper-CEST effect to be visible as a deviation of depletion curves (Fig. 2b). Application of the approach also to the host dilution series at 310 K (Fig. 2c) gave slightly less satisfying results. The same nominal concentrations as before were matched by the determinations 820±50 nM, 87±5 nM, 7.9±1.1 nM, and 0.85±0.45 nM.

A further mode of quantification may be applied which is distinguished in not relying on prior knowledge about the system parameters except $R$. The exchange rate $k_{on}(\rho)$ is at conditions of constant sample temperature and free xenon concentration (constant $\rho$) only susceptible to variations in the total host concentration. In such a situation, for a known host concentration $C_{ref}^{tot}$ the depletion rate when resonantly irradiated, denoted by $\delta_{satref}$, could be determined and subsequently used as a reference quantity in data evaluation. For a sample of unknown host concentration $C^{tot}$ the saturation driven depletion rate $\delta_{sat}$ is also experimentally determined in an identical manner such that the amount of substance can be revealed by comparison with the reference measurement and using the a-priori known rate $R$ according to the relation $C^{tot} = C_{ref}^{tot}\left(\delta_{sat} - R\right)/\left(\delta_{satref} - R\right)$.

The approach was applied to the host dilution series at 298 K and 310 K. For the reference, the sample with the highest host concentration (900 nM) was used to achieve a possibly low uncertainty in $\Delta_{ref}$. The nominal concentrations of 90 nM, 9 nM, and 0.9 nM were matched by the determinations 94±10 nM, 9.3±1.6 nM, 0.48±1.98 nM, and 96±4 nM, 8.7±1.2 nM, 0.93±0.49 nM, at 298 K and 310 K, respectively. At 310 K the quantification using the saturation driven depletion rate together with a priori known kinetics parameters discussed above, led to an underestimation of the host concentrations throughout the total dilution series. The present results alleviate this discrepancy to some extent which might be due to cancellation of a systematic misadjustment, e.g. a difference of the sample temperature in the experiments for determination of the kinetics parameters in comparison to the dilution series.

The proposed methods for quantification of the host concentration using Hyper-CEST can be applied in an alternative way by resorting to individually experimentally measured off-resonant signal intensities or depletion rates instead of using the pre-determined rate $R$ and polarizer performance $A(\rho)$ (using parameter $\alpha$). The first term of the model function stands for the signal intensity $s_0$ for off-resonant irradiation of specified duration $\tau$ and at specified xenon partial pressure $\rho$ expressed as $A(\rho)exp(-R\tau)$, while the intensity for resonantly applied irradiation $s_{sat}$ is given by $A(\rho)exp(-R\tau - k_{on}\tau)$. Thus, the model for the Hyper-CEST effect becomes $s_0 - s_{sat} = s_0(1-exp[-k_{on}\tau])$ in terms of the individually determined intensities $s_0$ and $s_{sat}$, assuming equivalent relaxation during irradiation ($R'=R$). Thus, explicit resolution of this alternative expression for the host concentration allows equally well quantitation. Applied to the data in Fig. 1c (90 nM CrA at 298 K), and again excluding mathematically intractable data (negative argument of logarithm, or result of negative host concentration), a host concentration of 83.8±3.8 nM was found in the mean with SD for 57 pairs of data.

Similarly, using singly, individually measured depletion rates $\delta_0$ and $\delta_{sat}$, for rf-irradiation applied off-resonantly or resonantly to a sample, the model implies $\delta_{sat}= \delta_0 + k_{on}$ with the saturation induced depletion rate again proportional to the host concentration via $k_{on}$. Application to the data in Fig. 1c gave a host concentration of 97.8±1.8 nM, and for the concentration dilution series at 298 K the results 0.94±2.84 nM and 9.2±1.6 nM and at 310 K the results 0.91±0.56 nM and 9.3±1.8 nM are obtained for nominally 0.9 nM and 9 nM (for 90 nM and 900 nM in the dilution series the rates $\delta_0$ were not determined), respectively.

Finally, a pair of rates for a known host concentration $C_{ref}^{tot}$, $\delta_{0ref}$ and $\delta_{satref}$, may be used as a reference measurement, rendering quantitation of an unknown amount of host with rates $\delta_0$ and $\delta_{sat}$ by the relation

$$C^{tot} = C_{ref}^{tot}\left(\delta_{sat} - \delta_0\right)/\left(\delta_{satref} - \delta_{0ref}\right)$$

possible. Using the rates for the nominally 0.9 n.M and 9 nM host concentration in the dilution series as references mutually, the numerical concentrations of 0.92±2.77 nM and 8.8±26.6 nM or 0.88±0.56 nM and 9.1±5.8 nM at 298 K or 310 K, respectively, were obtained. The rather large error margins reflect the acquisition of these data right at the detection limit (Fig. 2).

The different embodiments of the method may be applied in the field of biosensing with hyperpolarized xenon. A technology based on a model function for the key experimental approach is presented, the saturation transfer between host-bound and free xenon in the Hyper-CEST method. The amount of xenon (concentration) is introduced as the relevant quantity for controlling the experiment performance and data evaluation by the experimentalist based on knowledge about the NMR parameters governing the host-guest system. The optimal xenon concentration and saturation transfer period can be determined for applications at maximum effect, and quantitation of the amount of host becomes feasible. The method, exemplified for the widely used host CrA, may be applicable to other host structures currently investigated (see Mynar et al.,, J Am Chem Soc 128, 6334-6335 (2006); Stevens et al., J Am Chem Soc 135(26), 9576-9579 (2013); Shapiro et al., Nat Chem 6(7), 629-634 (2014); Wang et al., Chem Commun 51, 8982-8985 (2015)) because of the very same underlying mechanism of exchange driven saturation transfer. On the basis of such models different host candidates could be effectively compared in their performance of the intended application. For example, the model could be combined with a simulation of host based molecular imaging in deep tissue (see Shapiro et al., Nat Chem 6(7), 629-634 (2014)).

The the model function may be provided with modifications in alternative applications. It is based on the assumption of complete deletion of the magnetization of host-bound hpXe and thus requires rf irradiation of sufficiently high power for given lifetime of the complex. Within the regime of the presented experiments saturation by rf irradiation was complete, as is evident by the consistency of the quantitative results and former work on the hpXe-CrA host-guest system ( see Korchak et al., J Magn Reson 265, 139-145 (2016); Schröder et al., Phys Rev Lett 100, 257603 (2008)). For CrA at elevated temperature or for other hosts, e.g. cucurbituril molecules, the residence time can drop below the millisecond range, rendering rf saturation at manageable power levels difficult. It is, however, well known how to compensate for incomplete rf saturation in Hyper-CEST (see Zaiss et al., J Chem Phys 136 (14), 144106 (2012), Knuth M, Witte C, Schröder L, NMR Biomed 28(6), 601-606, (2015)). In the model function, the exchange rate $k_{on}$ needs to be scaled by the factor $\omega^2 / \left( \omega^2 + k_{off}^2 \right)$ to account for this effect. The angular frequency $\omega$ denotes the rf saturation power expressed in units of the hpXe precession frequency and $k_{off}$ the rate coefficient for magnetization transfer due to hpXe leaving the complex with the host (rate of dissociation of the complex of the marker substance and hpXe; rate of dissociation of the host-bound state of hpXe). This rate is readily available through the kinetics parameters as $k_{off} = c + k\rho$ and may be easily incorporated as a scaling factor to $k_{on}$ in the model function.

The establishment of a model function describing the saturation transfer in the CrA-hpXe host-guest system is based on a number of xenon and spin related parameters. The specifications (Table 1), mostly obtained by NMR (only the xenon solubility s may be taken from the literature or from other experiments), appear sufficiently accurate for the various applications of the model function presented. The reason is the rather smooth dependence on the system parameters. However, a strong impact on the overall appearance of the model function is due to the physical instrumentation, particularly the hyperpolarization and hpXe delivery equipment. The corresponding parameters ($\alpha$, and the overall amplitude) are prone to change with the setup, and need than to be re-determined. For example, the achievement of a higher level of spin polarization by the polarizer would, with the other parameters kept identical, immediately result in a correspondingly lower detection limit for the Hyper-CEST effect. Nonetheless, for given equipment and the specific host-guest system of interest, the methods presented here can be put to use at the little cost of a manageable effort for parameter specifications.

The quantification studies presented here are concerning amount of substance using the Hyper-CEST effect. This touches upon the important issue of quantitative molecular imaging. Evidence for the applicability of Hyper-CEST for quantification is shown for different approaches depending on the use of prior knowledge to a varying extent. The results obtained provide an accuracy and precision in the determination of the amount of host molecules (CrA) comparable to what is achieved with optical methods at similar concentration levels (see Noble et al., Clin Chem Lab Med 46(7), 1033-1045 (2008); Bunk et al., Metrologia 52(1A), 08006 (2015)). Applications of quantitative biosensing in-vitro may be provided, specifically ex-vitro. Importantly, CrA can be conjugated to a broad range of target-specific anti-bodies by modular techniques (see Rose et al., Proc Natl Acad Sci USa 111, 11697-11702 (2014)).

Following, further details are provided regarding materials and methods applied for embodiments described above.

With regard to sample preparation, monoacidic acid CrA (purchased from Kangyuan Jiyi Inc.) was dissolved in distilled water. The solution was sonicated for several hours at room temperature and finally pressed through a 0.2 $\mu$m-pore filter to remove non-dissolved particles. The concentration of CrA in the solution was measured by UV-Vis spectroscopy with the molar attenuation coefficient independently determined to be 16200 $M^{-1}cm^{-1}$. In this manner saturated solutions of CrA at concentrations less 7 $\mu$M were regularly obtained. For the dilution series, a saturated stock solution was prepared as described and stepwise further diluted.

The CrA-xenon association constant in water was determined using the fluorescence method described in Hill et al., J Am Chem Soc 129:9262-9263 (2007). The influence on the association constant of the 0.2 bar of N2 present in the gas mixture which was bubbled through the sample was independently determined analogously and taken into account. The kinetic exchange rate coefficients for CrA-xenon host-guest system in water at temperatures of 298 K and 310 K were determined by NMR exchange spectroscopy at variable xenon partial pressure (see Korchak et al., Chem Commun 51, 1721-1724 (2015)). For the small host concentration considered here, $R'=R$ was determined as the average of depletion rates from applications of the Hyper-CEST experiment off-resonantly. At each setting of the xenon partial pressure used for measuring the Hyper-CEST effect in dependence of $\rho$ and $\tau$ for 90 nM CrA (Fig. 1c), also a usual one-dimensional xenon spectrum was acquired. The respective signal intensities are a measure of the function $A(\rho)$ describing the polarizer performance in dependence of xenon partial pressure and were used for determination of the polarization parameter $\alpha$. Parameter uncertainties were determined by standard procedures, including statistical variances and error propagation.

NMR experiments were performed on a 7 T spectrometer (Bruker, Ettlingen, Germany) equipped with a double resonant probe for excitation and detection of $^1$H and $^{129}$Xe at 300 MHz and 83 MHz, respectively. The sample was maintained at 298 K or 310 K during the experiments using the VT-unit of the spectrometer. The signal of freely dissolved $^{129}$Xe was used for referencing the chemical shift scale and set to 193 ppm. For the measurements of the Hyper-CEST effect (Fig. 1c) and depletion curves (Fig. 2b, 2c) rf irradiation of an amplitude of 500 Hz in units of the xenon precession frequency was applied for a variable delay $\tau$ in the range of 0 s to 400 s and subsequently the free xenon magnetization selectively excited for acquisition by a Gaussian RF pulse of 1 ms length. The hyperpolarized $^{129}$Xe was generated by a custom-designed continuous-flow polarizer using spin-exchange-optical pumping (Korchak et al., Appl Magn Reson 44, 65-80 (2013)). The gas mixture of hpXe, nitrogen and helium at the outlet of the polarizer was transferred in a hose to the NMR tube in the spectrometer. The gas mixture was directly bubbled into the sample solution (3 ml) with the help of a spectrometer-triggered bubble dispenser (3.2 bar overpressure) via fused silica capillaries (Polymicro Technologies). The polarization depends on the xenon concentration subjected to the hyperpolarization process. A maximum of 25% was obtained at the lowest xenon partial pressure of 10 mbar while the minimum was 4% polarization at the highest xenon partial pressure of 0.8 bar.

With regard to evaluation of the experimental data, a total of 70 Hyper-CEST experiments, grouped in seven series with fixed xenon partial pressures of 0.01, 0.02, 0.05, 0.1, 0.2, 0.4, and 0.8 bar, were conducted for the solution of 90 nM CrA (Fig. 1c). For each series 10 fixed exchange delays $\gamma$ in the range of 0 s to 350 s were measured. In each experiment an FID of 16384 complex data points was acquired. After apodization by multiplication with an exponential filter function of width 20 Hz, each FID was Fourier-transformed. The spectra had just one signal (from free hpXe) which was phase corrected to absorption-mode, and the baselines were corrected. The signal in each spectrum was integrated over an area of 3 ppm centered at the signal's maximum amplitude. The software ACD/NMR Processor Academic Edition was used for spectrum integration. Identical procedures were applied for determination of signal intensities in case of the host dilution series but further processing applied. The signal intensities were modeled by functions in their dependence on the saturation transfer period for each setting of the xenon partial pressure by a non-linear least squares fit (Figs. 2b, 2c). In this way, the depletion rates were obtained for each setting of xenon partial pressure with error margins given by the standard error in the fit parameter due to deviations of the fitted curve from the data (square root of a main diagonal value of the Covariance Matrix). The commercially available software QtiPlot was used for data fitting.

Hyperpolarized xenon-129 is in conjunction with molecular host structures where it can reversibly bind to a formidable magnetic resonance probe for targeting of molecular and cellular markers. Marker location or marker-related functional events can be sensed at unprecedented low levels of concentration using the exchange driven saturation transfer between host-bound and unbound xenon. The amount of xenon used to report about the state of the host-guest system is a critical quantity in some embodiments and is a tool for controlling the performance and improving the analysis of applications. The dependence of the intrinsic magnetic resonance parameters spin polarization, spin relaxation rate, and binding rate on the xenon concentration facilitates a concise description of the outcome of measurements. This modeling allows experiments to be conducted optimally, including performance at the limit of detection, and enables the prognosis of future applications. In addition, quantitation, particularly the determination of amount of substance, becomes feasible.

While the methods for quantitatively determining an analyte in a liquid sample have been discussed for embodiments outlined above, it was found that such methods may be applied in a similar way to other host-guest-systems provided in a mixed liquid sample comprising a hyperpolarized gas, an analyte, and a marker substance, wherein the marker substance is bound to an analyte. The model function provided here considers two different processes which may occur in case of the hyperpolarized gas binding to the marker substance which in turn is bound to the analyte. The hyperpolarized gas molecule may find the marker substance molecule not occupied by another gas molecule of the same kind. As an alternative, the hyperpolarized gas molecule may bind to the marker substance molecule in exchange for a another gas molecule of the same kind which was bound to the marker substance molecule before. The method based on the model function may be applied to other host-guest systems showing similar behavior with regard to binding the hyperpolarized gas in the liquid sample.

Following, further aspects as to the polarizer performance in dependence of xenon partial pressures are provided.

The modeling of the spin polarization P in dependence of the xenon partial pressure p is based on the hyperpolarization process by spin exchange optical pumping (SEOP) (Freeman et al., Phys. Rev. A90:023406 (2014); Norquay et al., J. Appl. Phys. 113:044908 (2013)). With the parameters relevant to SEOP - except the xenon partial pressure - held constant, especially the residence time $\tau$res of the gas atoms inside the optical pumping cell and the temperature, one can assume all pumping rate coefficients also to be constant. The 129Xe polarization is then described by the well established formula

$$P = \langle P_{RB} \rangle \frac{\gamma_{SE}}{\gamma_{SE} + \Gamma_1} \left(1 - \exp\{-\tau_{res}(\gamma_{SE} + \Gamma_1)\}\right) \tag{S1}$$

where $\langle P_{Rb} \rangle$ is the cell-volume average Rubidium electron polarization, $\gamma_{SE}$ is the Rb-Xe spin-exchange rate, and $\Gamma_1$ is the 129Xe-relaxation rate.

The polarizer used in the present study operates at a total gas pressure of constantly 3 bar. As a consequence, $\gamma_{SE} = \kappa_{SE}[Rb]$ is dominated by the binary Rb-Xe collisions and is again constant in time because of a stationary Rubidium atom number-density [Rb] in the SEOP-cell at constant temperature. The 129Xe-relaxation rate $\Gamma_1$, mainly reflecting wall collisions and diffusion through magnetic field gradients, is a constant too because of the stable total gas pressure. However, the Rubidium polarization of steady state value

$$P_{Rb}(z) = \frac{\gamma_{OP}(z)}{\gamma_{OP}(z) + \Gamma_{SD}} \tag{S2}$$

is bound to vary with the amount of xenon in the SEOP cell. Here the optical pumping rate $\gamma_{OP}(z)$ is the spectral integral of the position-dependent laser intensity along the SEOP cell and the alkali-metal absorption cross section. For a given laser power and constant Rb concentration, this value again is independent the xenon partial pressure. In contrast, the alkali-metal spin-destruction rate $\Gamma_{SD} = \sum_i [G_i] \kappa_{SD}^{Rb-i}$ is strongly dependent on the various buffer-gas densities $[G_i]$ by way of the corresponding spin-destruction cross sections $\kappa_{SD}^{Rb-i}$. As shown in Table I in Norquay et al., J. Appl. Phys. 113:044908 (2013), xenon itself is the most dominant Rb-spin destroyer with a spin-destruction cross section about four orders of magnitude larger than for helium or nitrogen.

Eq. (S1) may thus be simplified as

$$P \propto \frac{P_0}{1 + \alpha p} \tag{S3}$$

with $P_0$ equal to the second and third factor in Eq. S1 multiplied by $\gamma_{OP}$, $p$ for the xenon partial pressure in the SEOP, and the parameter $\alpha$ approximately given by $\kappa_{SD}^{Rb-Xe}/\langle \gamma_{OP} \rangle$. The initial magnetization density of free xenon in a saturated solution at xenon partial pressure p is thus given by

$$A(\rho) = \frac{r P_0 \rho}{1 + (\alpha / s)\rho}$$

using Henry's law, $\rho = sp$. The parameter $\alpha$ was determined for the polarizer in the present study by measuring the spin polarization in dependence of $p$ (Eq. (S3)). Fig. 3 shows a graphical representation of a polarization of hpXe in dependence of xenon partial pressure. Experimental data (black dots) are signal intensities from usual one-dimensional NMR spectra of hpXe in aqueous solution saturated with the gas at the respective xenon partial pressure. The red line is a fit of the function $P$, the xenon polarization in Eq. (S3), to the data, to determine the parameter $\alpha = 8.36 \pm 0.76$ bar$^{-1}$. The amplitude $P_0$ is set by normalization to 25%.

Fig. 3 polarization of hpXe in dependence on xenon partial pressure;

Fig. 4 a graphical representation of an evaluation of the model function for the Hyper-CEST effect at temperature 298 K for an aqueous solution of CrA of (a) 0.9 nM, (b) 9 nM, (c) 90 nM, and (d) 900 nM, and at 310K for CrA concentrations of (e) 0.9 nM, (f) 9 nM, (g) 90 nM, and (h) 900 nM. The amplitudes are normalized to the maximum effect at 0.9 nM 298 K as is the case in Fig. 1c.

**Claims**

1. Method for quantitatively determining an analyte in a liquid sample, comprising

- providing a liquid sample comprising an analyte of interest and a marker substance bound to the analyte;
- preparing a mixed liquid sample by mixing the liquid sample with a hyperpolarized gas, the marker substance and the hyperpolarized gas providing a host-guest system in the mixed liquid sample, wherein the hyperpolarized gas is having a shift of nuclear magnetic resonance frequencies in case of a transition from a freely dissolved state to a host-bound state in which the hyperpolarized gas is bound to the marker substance in the mixed liquid sample;
- experimentally determining the mixed liquid sample by nuclear magnetic resonance (NMR) spectroscopy, comprising applying a Hyper-CEST method, which comprises:

  - in a first measurement, establishing a saturation transfer for the hyperpolarized gas in the freely dissolved state and the host-bound state, comprising depolarizing the hyperpolarized gas in the host-bound state by applying radio frequency (rf) irradiation in resonance with the hyperpolarized gas in the host-bound state for a time length $\tau$,
  - in a second measurement, establishing a non-saturation transfer for the hyperpolarized gas in the freely dissolved state and the host-bound state; and
  - detecting NMR signals for the hyperpolarized gas in the freely dissolved state;
  - determining a concentration of the hyperpolarized gas in the mixed liquid sample for the freely dissolved state; and
  - quantitatively determining the analyte in the liquid sample;

**characterized by** applying a model function S for the NMR signal as follows:

$$S(\rho, \tau) = A(\rho)e^{-R'(\rho)\tau} - A(\rho)e^{-(R+k_{on}(\rho))\tau},$$

wherein the first term of the model function S indicates the NMR signal for off-resonant irradiation without saturation transfer and the second term of the model function indicates the NMR signal in case of the resonant irradiation with saturation transfer, and

wherein $\rho$ - concentration of the hyperpolarized gas in the freely dissolved state, $k_{on}$ - association rate for binding of the hyperpolarized gas to the marker substance, $R$ - relaxation and direct saturation rate of free hyperpolarized gas in case of rf irradiation resonant with the host bound hyperpolarized gas, and $R'$ - relaxation and direct saturation rate of free hyperpolarized gas in case of rf irradiation off-resonant with the host bound hyperpolarized gas.

2. Method according to claim 1, wherein

   - the experimentally determining of the mixed liquid sample comprises experimentally determining a ratio of NMR signal intensities for the freely dissolved state and the host-bound state of the hyperpolarized gas; and
   - the determining of the concentration of the hyperpolarized gas comprises determining the concentration of the hyperpolarized gas in the host-bound state in the mixed liquid sample from the ratio of NMR signal intensities for the freely dissolved state and the host-bound state of the hyperpolarized gas.

3. Method according to at least one of the preceding claims, wherein the model function is applied for $R \cong R'$.

4. Method according to at least one of the preceding claims, wherein in the model function, the association rate $k_{on}$ is scaled by a factor $w^2/(w^2+k_{off}^2)$, wherein $w$ is a saturation rf-irradiation power expressed in units of the precession frequency of the hyperpolarized gas, and $k_{off}$ is a dissociation rate of a marker substance - hyperpolarized gas complex.

5. Method according to at least one of the preceding claims, wherein the preparing comprises mixing the liquid sample with hyperpolarized Xe.

6. Method according to at least one of the preceding claims, wherein the providing comprises providing a liquid sample with a sub-micromolar or a sub-nanomolar concentration of the analyte of interest.

7. Method according to at least one of the preceding claims, wherein the providing comprises providing a liquid sample with the marker substance selected from the following group: xenon binding substance, cryptophane, and cucurbituril.

8. Method according to at least one of claims 1 to 7, wherein the liquid sample is a liquid biological ex-vivo sample.

9. Use of the method according to at least one of claims 1 to 7 in a multiplexing mode for quantitation of a plurality of analytes by different markers used simultaneously.

**Patentansprüche**

1. Verfahren zur quantitativen Bestimmung eines Analyten in einer Flüssigkeitsprobe, umfassend

   - Bereitstellen einer Flüssigkeitsprobe, die einen Analyten von Interesse und eine an den Analyten gebundene Markersubstanz umfasst;
   - Herstellen einer gemischten Flüssigkeitsprobe durch Mischen der Flüssigkeitsprobe mit einem hyperpolarisierten Gas, wobei die Markersubstanz und das hyperpolarisierte Gas ein Wirts-Gast-System in der gemischten Flüssigkeitsprobe bereitstellen, wobei das hyperpolarisierte Gas eine Verschiebung der kernmagnetischen Resonanzfrequenzen im Falle eines Übergangs von einem frei gelösten Zustand zu einem wirtsgebundenen Zustand aufweist, in dem das hyperpolarisierte Gas an die Markersubstanz in der gemischten Flüssigkeitsprobe gebunden ist;
   - experimentelle Bestimmung der gemischten Flüssigkeitsprobe durch kernmagnetische Resonanzspektroskopie (NMR), wobei ein Hyper-CEST-Verfahren angewendet wird, das Folgendes umfasst:

     - in einer ersten Messung, Herstellen eines Sättigungstransfers für das hyperpolarisierte Gas im frei gelösten Zustand und im wirtsgebundenen Zustand, was das Depolarisieren des hyperpolarisierten Gases im wirtsgebundenen Zustand durch Anwenden von Hochfrequenz (HF)-Bestrahlung in Resonanz mit dem hyperpolarisierten Gas im wirtsgebundenen Zustand für eine Zeitlänge r umfasst,
     - in einer zweiten Messung, Herstellen eines Nicht-Sättigungstransfers für das hyperpolarisierte Gas im frei gelösten Zustand und im wirtsgebundenen Zustand; und
     - Nachweis von NMR-Signalen für das hyperpolarisierte Gas im frei gelösten Zustand;

   - Bestimmen einer Konzentration des hyperpolarisierten Gases in der gemischten Flüssigkeitsprobe für den frei gelösten Zustand; und
   - quantitative Bestimmung des Analyten in der Flüssigkeitsprobe;
   **gekennzeichnet durch** die Anwendung einer Modellfunktion S für das NMR-Signal wie folgt:

   $$S(\rho, \tau) = A(\rho)e^{-R'(\rho)\tau} - A(\rho)e^{-(R+k_{on}(\rho))\tau},$$

   wobei der erste Term der Modellfunktion $S$ das NMR-Signal für nicht-resonante Bestrahlung ohne Sättigungstransfer angibt und der zweite Term der Modellfunktion das NMR-Signal im Falle der resonanten Bestrahlung mit Sättigungstransfer angibt, und
   wobei $\rho$ - die Konzentration des hyperpolarisierten Gases im frei gelösten Zustand ist, $k_{on}$ - Assoziationsrate für die Bindung des hyperpolarisierten Gases an die Markersubstanz, $R$ - Relaxations- und direkte Sättigungsrate des freien hyperpolarisierten Gases im Falle der HF-Bestrahlung in Resonanz mit dem wirtsgebundenen hyperpolarisierten Gas und $R'$ - Relaxations- und direkte Sättigungsrate des freien hyperpolarisierten Gases im Falle der HF-Bestrahlung abseits der Resonanz mit dem wirtsgebundenen hyperpolarisierten Gas.

2. Verfahren nach Anspruch 1, wobei

   - die experimentelle Bestimmung der gemischten Flüssigkeitsprobe die experimentelle Bestimmung eines Verhältnisses der NMR-Signalintensitäten für den frei gelösten Zustand und den wirtsgebundenen Zustand des hyperpolarisierten Gases umfasst; und
   - die Bestimmung der Konzentration des hyperpolarisierten Gases die Bestimmung der Konzentration des hyperpolarisierten Gases im wirtsgebundenen Zustand in der gemischten Flüssigkeitsprobe aus dem Verhältnis der NMR-Signalintensitäten für den frei gelösten Zustand und den wirtsgebundenen Zustand des hyperpolarisierten Gases umfasst.

3. Verfahren nach mindestens einem der vorhergehenden Ansprüche, wobei die Modellfunktion für $R \cong R'$ angewendet wird.

**4.** Verfahren nach mindestens einem der vorhergehenden Ansprüche, **dadurch gekennzeichnet, dass** in der Modellfunktion die Assoziationsrate $k_{on}$ mit einem Faktor $w^2/(w^2+k_{off}^2)$ skaliert wird, wobei w eine Sättigungs-HF-Bestrahlungsleistung ist, ausgedrückt in Einheiten der Präzessionsfrequenz des hyperpolarisierten Gases, und $k_{off}$ eine Dissoziationsrate eines Markersubstanz-hyperpolarisierten Gaskomplexes ist.

**5.** Verfahren nach mindestens einem der vorhergehenden Ansprüche, wobei die Herstellung das Mischen der Flüssigkeitsprobe mit hyperpolarisiertem Xe umfasst.

**6.** Verfahren nach mindestens einem der vorhergehenden Ansprüche, wobei das Bereitstellen das Bereitstellen einer Flüssigkeitsprobe mit einer submikromolaren oder subnanomolaren Konzentration des interessierenden Analyten umfasst.

**7.** Verfahren nach mindestens einem der vorhergehenden Ansprüche, wobei das Bereitstellen das Versehen einer Flüssigkeitsprobe mit der Markersubstanz, ausgewählt aus der folgenden Gruppe: Xenonbindende Substanz, Cryptophan und Cucurbituril, umfasst.

**8.** Verfahren nach mindestens einem der Ansprüche 1 bis 7, wobei die Flüssigkeitsprobe eine flüssige biologische ex-vivo-Probe ist.

**9.** Verwendung des Verfahrens nach mindestens einem der Ansprüche 1 bis 7 in einem Multiplexing-Modus zur Quantifizierung einer Vielzahl von Analyten durch verschiedene gleichzeitig verwendete Marker.

## Revendications

**1.** Procédé de détermination quantitative d'un analyte dans un échantillon liquide, consistant à

- fournir un échantillon liquide comprenant un analyte d'intérêt et une substance marqueur liée à l'analyte ;
- préparer un échantillon liquide mixte en mélangeant l'échantillon liquide avec un gaz hyperpolarisé, la substance marqueur et le gaz hyperpolarisé constituant un système hôte-invité dans l'échantillon liquide mixte, dans lequel le gaz hyperpolarisé présente un décalage des fréquences de résonance magnétique nucléaire en cas de transition entre un état librement dissous et un état lié à l'hôte dans lequel le gaz hyperpolarisé est lié à la substance marqueur dans l'échantillon liquide mixte ;
- déterminer expérimentalement l'échantillon liquide mélangé par spectroscopie de résonance magnétique nucléaire (RMN), consistant à appliquer une méthode Hyper-CEST, qui comprend :

- dans une première mesure, l'établissement d'un transfert de saturation pour le gaz hyperpolarisé dans l'état librement dissous et l'état lié à l'hôte, comprenant la dépolarisation du gaz hyperpolarisé dans l'état lié à l'hôte en appliquant une irradiation par radiofréquence (rf) en résonance avec le gaz hyperpolarisé dans l'état lié à l'hôte pendant une durée de temps τ,
- dans une seconde mesure, établir un transfert de non-saturation pour le gaz hyperpolarisé dans l'état librement dissous et dans l'état lié à l'hôte ; et
- détecter des signaux RMN pour le gaz hyperpolarisé dans l'état librement dissous ;

- déterminer une concentration du gaz hyperpolarisé dans l'échantillon liquide mélangé pour l'état librement dissous ; et
- déterminer quantitativement l'analyte dans l'échantillon liquide ;
**caractérisé par** l'application d'une fonction de modèle S pour le signal RMN comme suit :

$$S(\rho,\tau) = A(\rho)e^{-R'(\rho)\tau} - A(\rho)e^{-(R + \kappa_{on}(\rho))\tau},$$

dans lequel le premier terme de la fonction de modèle S indique le signal RMN pour une irradiation hors résonance sans transfert de saturation et le second terme de la fonction de modèle indique le signal RMN dans le cas de l'irradiation résonante avec transfert de saturation, et
dans lequel ρ - la concentration du gaz hyperpolarisé à l'état librement dissous, $\kappa_{on}$ - le taux d'association pour la liaison du gaz hyperpolarisé à la substance marqueur, R - le taux de relaxation et de saturation directe du gaz hyperpolarisé libre en cas d'irradiation RF résonante avec le gaz hyperpolarisé lié à l'hôte, et R' - le taux de relaxation et de saturation directe du gaz hyperpolarisé libre en cas d'irradiation RF hors résonance avec le gaz hyperpolarisé lié à l'hôte.

2. Procédé selon la revendication 1, dans lequel

- la détermination expérimentale de l'échantillon de liquide mélangé consiste à déterminer expérimentalement un rapport des intensités des signaux RMN pour l'état librement dissous et l'état lié à l'hôte du gaz hyperpolarisé ; et
- la détermination de la concentration du gaz hyperpolarisé consiste à déterminer la concentration du gaz hyperpolarisé dans l'état lié à l'hôte dans l'échantillon liquide mélangé à partir du rapport des intensités des signaux RMN pour l'état librement dissous et l'état lié à l'hôte du gaz hyperpolarisé.

3. Procédé selon au moins l'une des revendications précédentes, dans lequel la fonction modèle est appliquée pour $R \cong R'$.

4. Procédé selon au moins l'une des revendications précédentes, dans lequel, dans la fonction modèle, le taux d'association $\kappa_{on}$ est mis à l'échelle par un facteur $\omega^2 / (\omega^2 + \kappa_{off}^2)$, dans lequel $\omega$ représente une puissance d'irradiation RF à saturation exprimée en unités de la fréquence de précession du gaz hyperpolarisé, et $\kappa_{off}$ un taux de dissociation d'un complexe substance de marquage - gaz hyperpolarisé.

5. Procédé selon au moins une des revendications précédentes, dans lequel la préparation consiste à mélanger l'échantillon liquide avec du Xe hyperpolarisé.

6. Procédé selon l'une au moins des revendications précédentes, dans lequel la fourniture consiste à fournir un échantillon liquide avec une concentration sub-micromolaire ou subnanomolaire de l'analyte d'intérêt.

7. Procédé selon au moins l'une des revendications précédentes, dans lequel l'apport consiste à fournir un échantillon liquide avec la substance marqueur choisie dans le groupe suivant : une substance liant le xénon, le cryptophane et le cucurbituril.

8. Procédé selon au moins une des revendications 1 à 7, dans lequel l'échantillon liquide est un échantillon biologique liquide ex-vivo.

9. Utilisation du procédé selon l'une quelconque des revendications 1 à 7 dans un mode de multiplexage pour la quantification d'une pluralité d'analytes par différents marqueurs utilisés simultanément.

Fig. 1

Fig. 2a

EP 3 330 729 B1

Fig. 2b

Fig. 2c

Fig. 3

Fig. 4

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **WALKER et al.** *Rev Mod Phys,* 1997, vol. 69, 629-642
- **BARTIK et al.** *J Am Chem Soc,* 1998, vol. 120, 784-791
- **SCHRÖDER et al.** *Science,* 2006, vol. 314, 446-449
- **KUNTH et al.** *Chem Sci,* 2015, vol. 6, 6069-6075
- *Journal of Chemical Physics,* 21 November 2014, vol. 141 (19
- **BAI et al.** *Anal Chem,* 2012, vol. 84 (22), 9935-9941
- **KORCHAK SE ; KILIAN W ; MITSCHANG L.** *Appl Magn Reson,* 2013, vol. 44, 65-80
- **ZAISS et al.** *J Chem Phys,* 2012, vol. 136 (14), 144106
- **KORCHAK et al.** *J Magn Reson,* 2016, vol. 265, 139-145
- **KORCHAK et al.** *Chem Commun,* 2015, vol. 51, 1721-1724
- **HILL et al.** *J Am Chem Soc,* 2007, vol. 129, 9262-9263
- **CLEVER HL.** Solubility Data Series. Pergamon press, 1979, vol. 2, 134-227
- **KITANI et al.** *Clin Lab Invest,* 1972, vol. 29, 167-172
- **YEH et al.** *Pharm Sci,* 1964, vol. 53 (7), 822-824
- **MYNAR et al.** *J Am Chem Soc,* 2006, vol. 128, 6334-6335
- **STEVENS et al.** *J Am Chem Soc,* 2013, vol. 135 (26), 9576-9579
- **SHAPIRO et al.** *Nat Chem,* 2014, vol. 6 (7), 629-634
- **WANG et al.** *Chem Commun,* 2015, vol. 51, 8982-8985
- **SCHRÖDER et al.** *Phys Rev Lett,* 2008, vol. 100, 257603
- **KNUTH M ; WITTE C ; SCHRÖDER L.** *NMR Biomed,* 2015, vol. 28 (6), 601-606
- **NOBLE et al.** *Clin Chem Lab Med,* 2008, vol. 46 (7), 1033-1045
- **BUNK et al.** *Metrologia,* 2015, vol. 52 (1A), 08006
- **ROSE et al.** *Proc Natl Acad Sci USa,* 2014, vol. 111, 11697-11702
- **KORCHAK et al.** *Appl Magn Reson,* 2013, vol. 44, 65-80
- **FREEMAN et al.** *Phys. Rev.,* 2014, vol. A90, 023406
- **NORQUAY et al.** *J. Appl. Phys.,* 2013, vol. 113, 044908